(19) Europäisches Patentamt
European Patent Office
Office européen des brevets

(11) **EP 3 970 275 B1**

(12) **FASCICULE DE BREVET EUROPEEN**

(45) Date de publication et mention de la délivrance du brevet:
**07.06.2023 Bulletin 2023/23**

(21) Numéro de dépôt: **21755530.9**

(22) Date de dépôt: **19.07.2021**

(51) Classification Internationale des Brevets (IPC):
**H03M 13/11** *(2006.01)* **H03M 13/29** *(2006.01)*
**H03M 13/35** *(2006.01)*

(52) Classification Coopérative des Brevets (CPC):
**H03M 13/116; H03M 13/1174; H03M 13/2906;
H03M 13/2945; H03M 13/353; H03M 13/6502;
H03M 13/6516**

(86) Numéro de dépôt international:
**PCT/FR2021/051347**

(87) Numéro de publication internationale:
**WO 2022/023641 (03.02.2022 Gazette 2022/05)**

(54) **DISPOSITIF ET PROCEDE D'ENCODAGE EFFICACE DE CODES LDPC QUASI-CYCLIQUES**

VORRICHTUNG UND VERFAHREN ZUR EFFIZIENTEN ENKODIERUNG VON QUASI-ZYKLISCHEN LDPC KODES

DEVICE AND METHOD FOR EFFICIENT ENCODING OF QUASI-CYCLIC LDPC CODES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **31.07.2020 FR 2008173**

(43) Date de publication de la demande:
**23.03.2022 Bulletin 2022/12**

(73) Titulaire: **Airbus Defence and Space SAS
31402 Toulouse Cedex 4 (FR)**

(72) Inventeurs:
• **Gadat, Benjamin
31402 Toulouse Cedex 4 (FR)**
• **Barthe, Lyonel
31402 Toulouse Cedex 4 (FR)**

(74) Mandataire: **Plasseraud IP
66, rue de la Chaussée d'Antin
75440 Paris Cedex 09 (FR)**

(56) Documents cités:
**US-A1- 2011 264 987 US-A1- 2016 154 697**

• **ALFIRAS MOHANAD ET AL: "Hybrid Concatenated LDPC Codes with LTE Modulation Schemes", INTERNATIONAL JOURNAL OF ADVANCED COMPUTER SCIENCE AND APPLICATIONS , vol. 10, no. 5 1 janvier 2019 (2019-01-01), XP055786239, ISSN: 2158-107X, DOI: 10.14569/IJACSA.2019.0100564 Extrait de l'Internet: URL:https://pdfs.semanticscholar.org/7040/ 3ba4733a6c3ac38bf9d87d2f9d07b980f2f9.pdf [extrait le 2021-03-16]**
• **CHRISTIAN KOLLER ET AL: "Hybrid concatenated codes with asymptotically good distance growth", PROC. 5TH INTERNATIONAL SYMPOSIUM ON TURBO CODES AND RELATED TOPICS 2008, IEEE, PISCATAWAY, NJ, USA, 1 septembre 2008 (2008-09-01), pages 19-24, XP031353656, ISBN: 978-1-4244-2862-5**
• **YIFEI ZHANG ET AL: "Structured eIRA codes with low floors", PROC. INTERNATIONAL SYMPOSIUM ON INFORMATION THEORY 2005 (ISIT 2005), ADELAIDE, AUSTRALIA 4-9 SEPT. 2005, PISCATAWAY, NJ, USA, 4 septembre 2005 (2005-09-04), pages 174-178, XP010846236, DOI: 10.1109/ISIT.2005.1523317 ISBN: 978-0-7803-9151-2**

- **THEODOROPOULOS DIMITRIS ET AL: "Efficient Architectures for Multigigabit CCSDS LDPC Encoders", IEEE TRANSACTIONS ON VERY LARGE SCALE INTEGRATION (VLSI) SYSTEMS, IEEE SERVICE CENTER, PISCATAWAY, NJ, USA, vol. 28, no. 5, 2 mars 2020 (2020-03-02), pages 1118-1127, XP011785748, ISSN: 1063-8210, DOI: 10.1109/TVLSI.2020.2975050 [extrait le 2020-04-23]**
- **LIANG CHEN ET AL: "Implementation of Multi-Rate Quasi-Cyclic Low-Density Parity-Check Codes", THE 9TH INTERNATIONAL CONFERENCE ON ADVANCED COMMUNICATION TECHNOLOGY, vol. 2, 1 janvier 2007 (2007-01-01), pages 1066-1070, XP055312585, ISSN: 1738-9445, DOI: 10.1109/ICACT.2007.358542 ISBN: 978-89-551913-1-8**

## Description

### Domaine technique

La présente invention appartient au domaine des communications numériques, et concerne plus particulièrement un dispositif et un procédé d'encodage de codes à contrôle de parité à faible densité, dits codes LDPC (« Low Density Parity Check » dans la littérature anglo-saxonne).

### Etat de la technique

Les codes LDPC sont de plus en plus répandus, dans les systèmes de communication terrestre ou par satellite (voir [Mohanad], [Koller], [Zhang], [Dimitris], [Chen], US 2016/154697 A1, US 2011/264987 A1).

Par exemple, le standard de communication 5G défini par l'ETSI « European Télécommunication Standards Institute ») intègre des codes LDPC. Également, le standard DVB-S2 (« Digital Vidéo Broadcast-Satellite Second Génération ») de diffusion vidéo par satellite intègre des codes LDPC.

Actuellement, le CCSDS (« Consultative Committee for Space Data Systems »), qui réunit notamment les principales agences spatiales mondiales, est en train de définir un standard de communication pour lequel des codes LDPC ont été définis par la société AIRBUS DEFENCE AND SPACE et proposés par le Centre National d'Etudes Spatiales, CNES. Le débit de transmission envisagé, de l'ordre de 10 Gbits/s, permettrait notamment à des satellites d'observation de transmettre rapidement au sol une quantité importante de données d'observation.

Le standard de communication en cours de définition par le CCSDS est prévu pour comporter une pluralité de codes LDPC différents, permettant d'adapter le code LDPC utilisé aux conditions de transmission et/ou à la quantité de données à transmettre. Notamment, plusieurs taux de codage sont envisagés pour les codes LDPC. Il est également envisagé d'utiliser des codes LDPC de types différents. En particulier, il est envisagé d'utiliser un premier type de codes LDPC pour les taux de codage les plus faibles, et d'utiliser un second type de codes LDPC pour les taux de codage les plus élevés.

Toutefois, une telle flexibilité, en termes de taux de codage et de type de code LDPC, couplée à un débit de transmission élevé, est particulièrement complexe à atteindre. Surtout dans le cas d'un dispositif d'encodage à embarquer dans un satellite, pour lequel les composants de calcul pouvant être utilisés, c'est-à-dire qualifiés pour le vol spatial, sont peu nombreux et présentent généralement des performances inférieures à celles des composants de calcul pouvant être utilisés au sol.

Il existe donc un besoin pour une architecture de dispositif d'encodage permettant à la fois d'implémenter de manière flexible différents types de codes LDPC, qui soit en outre compatible avec des débits de transmission élevés. Une telle architecture présenterait un intérêt dans le contexte du standard défini par le CCSDS, mais également, plus généralement, pour tout système de communication susceptible d'utiliser différents types de codes LDPC.

### Exposé de l'invention

La présente invention a pour objectif de remédier à tout ou partie des limitations des solutions de l'art antérieur, notamment celles exposées ci-avant, en proposant une solution qui permet d'implémenter de manière flexible différents types de codes LDPC, et qui est en outre compatible avec des débits de transmission élevés.

A cet effet, et selon un premier aspect, il est proposé un dispositif d'encodage de données adapté à encoder une pluralité de codes LDPC, ledit dispositif d'encodage comportant une interface d'entrée pour recevoir des données d'un paquet de données à encoder et une interface de sortie pour fournir des données encodées. Ledit dispositif d'encodage comporte :

- un premier circuit multiplexeur et un second circuit multiplexeur, ledit premier circuit multiplexeur étant relié en entrée à l'interface d'entrée et en sortie à l'entrée dudit second circuit multiplexeur, ledit second circuit multiplexeur étant relié en sortie à l'interface de sortie,
- un premier circuit d'encodage de code LDPC quasi-cyclique, relié en entrée à l'interface d'entrée et en sortie à l'entrée du premier circuit multiplexeur,
- un second circuit d'encodage de code LDPC quasi-cyclique, relié en entrée à l'interface d'entrée et en sortie à l'entrée du premier circuit multiplexeur, ledit second circuit d'encodage étant agencé en parallèle avec ledit premier circuit d'encodage,
- un troisième circuit d'encodage de code LDPC quasi-cyclique, relié en entrée à la sortie du premier circuit multiplexeur et en sortie à l'entrée du second circuit multiplexeur.

Ainsi, le dispositif d'encodage comporte trois circuits d'encodage de codes LDPC quasi-cycliques. Les codes LDPC quasi-cycliques correspondent à un type général de code LDPC, bien connus de l'homme de l'art (voir par exemple [Foss]). Les codes LDPC quasi-cycliques sont connus pour permettre un encodage et un décodage efficace par une parallélisation possible de nombreux traitements, et pour lesquels de nombreuses architectures optimisées existent. De tels codes LDPC quasi-cycliques sont donc particulièrement adaptés pour des applications visant des débits de transmission élevés, de l'ordre de plusieurs Gbits/s, comme c'est le cas notamment pour le standard défini par le CCSDS.

En outre, de nombreux types particuliers de codes LDPC correspondent à des codes LDPC quasi-cycliques et/ou à des juxtapositions et/ou à des combinaisons de codes LDPC quasi-cycliques. Par exemple, un code LDPC à simple contrôle de parité, dit code LDPC SPC (« Single Parity Check » dans la littérature anglo-saxonne) est un type particulier de code LDPC quasi-cyclique. De même, un code LDPC à répétition irrégulière-accumulation, dit code LDPC IRA (« Irregular Repeat Accumulate ») est un type particulier de code LDPC quasi-cyclique.

En outre, les trois circuits d'encodage de codes LDPC comportent :

- un premier circuit d'encodage de code LDPC et un second circuit d'encodage de code LDPC agencés en parallèle, permettant de réaliser des codes LDPC juxtaposant des codes LDPC quasi-cycliques ; par exemple la juxtaposition d'un code LDPC IRA et d'un code LDPC SPC permet d'obtenir un code LDPC à accumulation répétition accumulation, dit code LDPC ARA (« Accumulate Repeat Accumulate ») ;
- un troisième circuit d'encodage de code LDPC agencé en série avec les premier et second circuits d'encodage de codes LDPC quasi-cycliques, ce qui permet de combiner des codes LDPC quasi-cycliques en série, en injectant dans le troisième circuit d'encodage de code LDPC quasi-cyclique des données encodées par le premier et/ou le second circuit d'encodage de code LDPC.

On comprend donc qu'une telle architecture de dispositif d'encodage permet de former de nombreux types différents de codes LDPC, au moyen de configurations adaptées des trois circuits d'encodage de codes LDPC quasi cycliques. Une telle architecture permet notamment de former les différents types de codes LDPC proposés pour le standard en cours de définition par le CCSDS, qui comportent :

- des codes LDPC ARA juxtaposant des codes LDPC IRA et SPC en parallèle pour les taux de codage les plus élevés,
- des codes LDPC combinant des codes LDPC ARA et SPC en série (qui peuvent être considérés comme étant semblables à des codes Raptor) pour les taux de codage les plus faibles.

Outre le fait que les codes LDPC quasi-cycliques sont particulièrement adaptés pour des applications visant des débits de transmission élevés, l'architecture du dispositif d'encodage proposé permet également d'effectuer de nombreux traitements en parallèle.

Par exemple, les premier et second circuits d'encodage de code LDPC peuvent encoder des données en parallèle pour la réalisation d'un même mot de code LDPC. En outre, les accès en écriture, dont les durées peuvent s'avérer critiques pour des débits de transmission de l'ordre du Gbits/s, peuvent être fortement parallélisés. Par exemple, il est possible d'écrire en parallèle les données à encoder dans des mémoires tampon d'entrée respectives des trois circuits d'encodage de codes LDPC tout en écrivant, dans un mémoire tampon de sortie du dispositif d'encodage, des données à inclure à l'identique dans le mot de code LDPC (bits systématiques).

En pratique, les inventeurs ont vérifié qu'une telle architecture de dispositif d'encodage permettait d'atteindre un débit de transmission de 10 Gbits/s pour des codes LDPC combinant des codes ARA et SPC en série, conformes aux codes LDPC proposés pour le standard CCSDS, au moyen d'un circuit logique programmable de type FPGA (« Field-Programmable Gate Array ») commercialisé par la Société Xilinx® sous la référence KU060.

Dans des modes particuliers de réalisation, le dispositif d'encodage peut comporter en outre l'une ou plusieurs des caractéristiques suivantes, prises isolément ou selon toutes les combinaisons techniquement possibles.

Dans des modes particuliers de réalisation, le dispositif d'encodage comporte au moins une mémoire dans laquelle sont mémorisées des informations de configuration comportant :

- au moins une matrice d'encodage de code LDPC IRA pour configurer le premier circuit d'encodage,
- au moins une matrice d'encodage de code LDPC SPC pour configurer le second circuit d'encodage,
- au moins une matrice d'encodage de code LDPC SPC pour configurer le troisième circuit d'encodage.

Dans des modes particuliers de réalisation, au moins une matrice d'encodage de code LDPC est mémorisée partiellement, des lignes ou colonnes adjacentes de ladite matrice d'encodage de code LDPC qui sont constituées de valeurs nulles n'étant pas mémorisées. De telles dispositions permettent de réduire l'empreinte mémoire pour la configuration des circuits d'encodage de codes LDPC, et permettent également d'accélérer l'encodage en évitant de charger/décharger des valeurs non utilisées en pratique.

Dans des modes particuliers de réalisation, le troisième circuit d'encodage comporte une mémoire tampon d'entrée de taille adaptée à mémoriser des données correspondant à au moins deux paquets de données à encoder. De telles dispositions permettent de paralléliser davantage les traitements, en permettant de réaliser l'écriture en mémoire tampon d'entrée de données du paquet de données suivant tout en effectuant l'encodage des données du paquet de données en cours.

Dans des modes particuliers de réalisation, le premier circuit multiplexeur est relié au second circuit multiplexeur par l'intermédiaire d'une mémoire tampon. Grâce à cette mémoire tampon, l'écriture des mots de code LDPC sur l'interface de sortie du dispositif d'encodage est plus efficace car elle peut être réalisée sur des blocs de données en mode rafale pour optimiser l'utilisation de la bande passante de l'interface de sortie (« burst accesses » dans la littérature anglo-saxonne).

Dans des modes particuliers de réalisation, la mémoire tampon entre le premier circuit multiplexeur et le second circuit multiplexeur est de type premier entré-premier sorti.

Dans des modes particuliers de réalisation, la mémoire tampon entre le premier circuit multiplexeur et le second circuit multiplexeur est de taille adaptée à mémoriser des données correspondant à au moins deux paquets de données à encoder. De telles dispositions permettent de paralléliser davantage les traitements, en permettant de réaliser l'écriture dans cette mémoire tampon de données du paquet de données suivant à inclure à l'identique (bits systématiques) pendant que le troisième circuit d'encodage de code LDPC effectue l'encodage des données du paquet de données en cours.

Dans des modes particuliers de réalisation, le dispositif d'encodage est configuré pour encoder des codes LDPC dont la matrice de parité H peut être mise sous la forme suivante :

$$H = \begin{pmatrix} A & 0 & D \\ B & E & 0 \end{pmatrix}$$

ou selon la forme suivante :

$$H = \begin{pmatrix} A & 0 & D & 0 \\ B & E & 0 & 0 \\ C' & C'' & C''' & F \end{pmatrix}$$

expressions dans lesquelles les matrices **E** et **F** sont des matrices diagonales (matrices identités), et la matrice **D** est une matrice à double diagonale. En particulier, les codes LDPC proposés pour le standard défini le CCSDS peuvent être exprimés sous ces formes (code LDPC ARA d'une part, et combinaison de codes LPDC ARA et SPC en série d'autre part).

Dans des modes particuliers de réalisation, le dispositif d'encodage est configuré pour encoder en outre des codes LDPC dont la matrice de parité **H** peut être mise sous la forme suivante :

$$H = \begin{pmatrix} A & D \end{pmatrix}$$

Selon un second aspect, il est proposé un satellite comportant un dispositif d'encodage selon l'un quelconque des modes de réalisation de l'invention.

Dans des modes particuliers de réalisation du satellite, les données encodées sont transmises sur une liaison optique et/ou les données encodées sont transmises à un débit supérieur à 5 Gbits/s, par exemple 10 Gbits/s.

Selon un troisième aspect, il est proposé un procédé d'encodage de codes LDPC au moyen d'un dispositif d'encodage selon l'un quelconque des modes de réalisation de l'invention. Le procédé d'encodage comporte :

- une écriture en parallèle de données d'un paquet de données à encoder dans des mémoires tampons d'entrée respectives du premier circuit d'encodage, du second circuit d'encodage et du troisième circuit d'encodage,
- un encodage en parallèle des données en mémoire tampon d'entrée par le premier circuit d'encodage et le second circuit d'encodage,
- une écriture de données encodées par respectivement le premier circuit d'encodage et le second circuit d'encodage dans la mémoire tampon d'entrée du troisième circuit d'encodage,
- un encodage des données en mémoire tampon d'entrée par le troisième circuit d'encodage.

Dans des modes particuliers de mise en oeuvre, le procédé d'encodage peut comporter en outre l'une ou plusieurs des caractéristiques suivantes, prises isolément ou selon toutes les combinaisons techniquement possibles.

Dans des modes particuliers de mise en oeuvre, le procédé d'encodage comporte, en parallèle de l'encodage par le troisième circuit d'encodage, une écriture en parallèle de données d'un autre paquet de données à encoder dans les mémoires tampons d'entrée respectives du premier circuit d'encodage, du second circuit d'encodage et du troisième circuit d'encodage.

Dans des modes particuliers de mise en oeuvre, le dispositif d'encodage comportant une mémoire tampon entre le premier circuit multiplexeur et le second circuit multiplexeur, les données du paquet de données sont écrites dans ladite mémoire tampon en parallèle de l'écriture dans les mémoires tampons d'entrée respectives du premier circuit d'encodage, du second circuit d'encodage et du troisième circuit d'encodage.

Selon un quatrième aspect, il est proposé un produit programme de configuration comportant des instructions qui, lorsqu'elles sont mises en oeuvre pour configurer un circuit logique programmable, configurent ledit circuit logique programmable pour former un dispositif d'encodage selon l'un quelconque des modes de réalisation de l'invention. Les instructions du produit programme de configuration sont par exemple en langage haut niveau (par exemple VHDL, Verilog, etc.) ou en langage bas niveau (correspondant à du langage haut niveau compilé pour le circuit logique programmable considéré).

**Présentation des figures**

L'invention sera mieux comprise à la lecture de la description suivante, donnée à titre d'exemple nullement limitatif, et faite en se référant aux figures qui représentent :

- Figure 1 : une représentation schématique d'un exemple de réalisation d'un dispositif d'encodage de codes LDPC,
- Figure 2 : une représentation schématique d'un exemple de réalisation d'un circuit d'encodage de code LDPC quasi-cyclique,
- Figure 3 : une représentation schématique d'un mode préféré de réalisation d'un dispositif d'encodage de codes LDPC,
- Figure 4 : une représentation schématique d'un exemple de matrice d'encodage pour un code LDPC IRA,
- Figure 5 : une représentation schématique d'un exemple de matrice d'encodage pour un premier code LDPC SPC,
- Figure 6 : une représentation schématique d'un exemple de matrice d'encodage pour un second code LDPC SPC,
- Figure 7 : un diagramme illustrant les principales étapes d'un exemple de mise en oeuvre d'un procédé d'encodage de code LDPC,
- Figure 8 : une représentation schématique illustrant la mise en oeuvre d'une étape du procédé d'encodage de la figure 7,
- Figure 9 : une représentation schématique illustrant la mise en oeuvre d'une étape du procédé d'encodage de la figure 7,
- Figure 10: une représentation schématique illustrant la mise en oeuvre d'une étape du procédé d'encodage de la figure 7,
- Figure 11 : une représentation schématique illustrant la mise en oeuvre d'une étape du procédé d'encodage de la figure 7.

Dans ces figures, des références identiques d'une figure à une autre désignent des éléments identiques ou analogues. Pour des raisons de clarté, les éléments représentés ne sont pas à l'échelle, sauf mention contraire.

**Description des modes de réalisation**

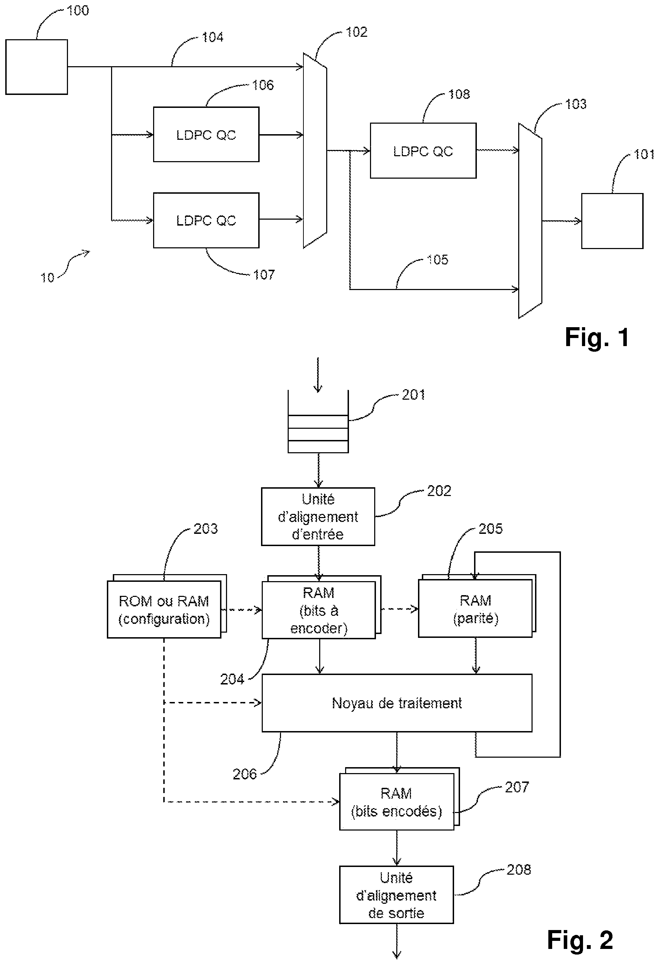

La figure 1 représente schématiquement un mode particulier de réalisation d'un dispositif 10 d'encodage adapté à encoder une pluralité de codes LDPC.

Le dispositif 10 d'encodage comporte par exemple un ou des circuits logiques programmables, de type FPGA, PLD, etc., et/ou un ou des circuits intégrés spécialisés (ASIC), configurés pour réaliser les différents traitements d'encodage des codes LDPC. Dans le cas d'applications spatiales visant des débits de transmission de l'ordre de quelques Gbits/s, le dispositif 10 d'encodage est par exemple implémenté par un ASIC ou par un circuit logique programmable de type FPGA (par exemple le modèle Xilinx® KU060).

Tel qu'illustré par la figure 1, le dispositif 10 d'encodage comporte une interface d'entrée 100, pour recevoir des données à encoder d'un paquet de données, et une interface de sortie 101, pour fournir des données encodées obtenues à partir des données reçues sur l'interface d'entrée 100. Suivant un exemple non limitatif, l'interface d'entrée 100 et l'interface de sortie 101 peuvent mettre en oeuvre le protocole d'interface AXI4 (« Advanced eXtensible Interface-4 ») ou dérivé dudit protocole d'interface AXI4. Toutefois, tout type de protocole d'interface compatible avec le débit de transmission souhaité peut être considéré pour l'interface d'entrée 100 et l'interface de sortie 101, qui peuvent en outre utiliser des protocoles d'interface différents.

En outre, le dispositif 10 d'encodage comporte un premier circuit multiplexeur 102 et un second circuit multiplexeur 103.

Tel qu'illustré par la figure 1, le premier circuit multiplexeur 102 est relié en entrée, par une liaison 104, à l'interface d'entrée 100 du dispositif 10 d'encodage. Le premier circuit multiplexeur 102 est également relié en sortie, par une liaison 105, à l'entrée du second circuit multiplexeur 103. Le second circuit multiplexeur 103 est en outre relié en sortie à l'interface de sortie 101 du dispositif 10 d'encodage. Ainsi, l'interface de sortie 101 est reliée à l'interface d'entrée 100 par l'intermédiaire du premier circuit multiplexeur 102 et du second circuit multiplexeur 103, via les liaisons 104 et 105, et ce trajet permet notamment de fournir sur l'interface de sortie 101 des données qui sont incluses à l'identique dans les mots de code LDPC (bits systématiques des mots de code LDPC).

Tel qu'illustré par la figure 1, le dispositif 10 d'encodage comporte, agencés en parallèle entre eux et avec la liaison 104, un premier circuit d'encodage 106 de code LDPC quasi-cyclique et un second circuit d'encodage 107 de code LDPC quasi-cyclique. Ainsi, il existe trois trajets parallèles entre l'interface d'entrée 100 et le premier circuit multiplexeur 102, via respectivement la liaison 104, le premier circuit d'encodage 106 et le second circuit d'encodage 107.

Le dispositif 10 d'encodage comporte également, agencé en parallèle avec la liaison 105, un troisième circuit d'encodage 108 de code LDPC quasi-cyclique. Ainsi, il existe deux trajets parallèles entre le premier circuit multiplexeur 102 et le second circuit multiplexeur 103, via respectivement la liaison 105 et le troisième circuit d'encodage 108.

Tel qu'indiqué précédemment, le dispositif 10 d'encodage comporte trois circuits d'encodage 106, 107, 108 de codes LDPC quasi-cycliques. Les codes LDPC quasi-cycliques sont connus pour permettre un encodage efficace par une parallélisation de nombreux traitements. Pour de tels codes LDPC quasi-cycliques, on définit généralement un facteur d'expansion $Z$ (ou taille de circulante), qui correspond à la taille maximale des blocs pouvant être traités en parallèle par ligne de circulante. Par exemple, dans le cas de certains codes LDPC proposés pour le standard défini par le CCSDS, le facteur d'expansion est égal à $Z = 128$, et la taille des mots de code LDPC est constante quel que soit le type de code LDPC considéré ou le taux de codage considéré, égale à 30720 bits. Le fait de considérer une taille de mots de code LDPC constante, par exemple égale à 30720 bits, permet de dimensionner les traitements de manière homogène pour tous les taux de codage.

Tel qu'indiqué précédemment, il existe dans la littérature de nombreuses architectures possibles pour l'implémentation de tels codes LDPC quasi-cycliques. La figure 2 représente schématiquement un exemple non-limitatif d'architecture pouvant être utilisée pour chacun des circuits d'encodage 106, 107, 108 de codes LDPC quasi-cycliques du dispositif 10 d'encodage. Dans l'exemple illustré par la figure 2, le circuit d'encodage 106, 107, 108 comporte :

- une mémoire tampon d'entrée 201, de type premier entré-premier sorti (« First In First Out » ou FIFO dans la littérature anglo-saxonne),
- une unité d'alignement d'entrée 202, qui permet de former des blocs de bits de données à encoder de la taille du facteur d'expansion $Z$,
- une mémoire volatile ou non-volatile 203 (« Random Access Memory » ou RAM, « Read-Only Memory » ou ROM) dans laquelle sont mémorisées des informations de configuration relatives à un ou plusieurs codes LDPC supportés, comme par exemple les matrices d'encodage à utiliser (qui peuvent être mémorisées sous toute forme adaptée), ou encore le nombre et les positions d'éventuels bits à poinçonner, le nombre et les positions des bits systématiques, le nombre et les positions des bits de parité, etc.,
- des mémoires volatiles 204 et 205, pour mémoriser respectivement des blocs de bits avant encodage et des blocs de bits de parité, de la taille du facteur d'expansion $Z$,
- un noyau de traitement 206 pour effectuer les différents traitements d'encodage, basé principalement sur des portes logiques de type XOR,
- une mémoire volatile de sortie 207, pour mémoriser provisoirement les blocs de bits de données encodées de la taille du facteur d'expansion $Z$,
- une unité d'alignement de sortie 208, qui adapte la taille des blocs de bits de données encodées à la taille attendue en sortie du circuit d'encodage 106, 107, 108.

Bien évidemment, il existe d'autres architectures pouvant être utilisées pour chacun des circuits d'encodage 106, 107, 108 de codes LDPC quasi-cycliques, et le choix d'une architecture particulière ne constitue qu'une variante d'implémentation de l'invention.

Dans l'exemple illustré par la figure 2, les informations de configuration sont mémorisées dans une mémoire volatile ou non-volatile 203 interne au circuit d'encodage 106, 107, 108. Rien n'exclut cependant, suivant d'autres exemples, de considérer d'autres configurations pour la mémorisation des informations de configuration. Par exemple, il est possible de regrouper les informations de configuration des trois circuits d'encodage 106, 107, 108 de codes LDPC quasi-cycliques dans une seule mémoire volatile ou non-volatile partagée par lesdits trois circuits d'encodage 106, 107, 108.

Dans le cas où le dispositif 10 d'encodage est implémenté au moins en partie sur un circuit logique programmable FPGA, les informations de configuration sont par exemple mémorisées dans une ou plusieurs mémoires volatiles dudit FPGA dont le contenu est chargé à l'initialisation dudit FPGA, à partir d'une ou plusieurs mémoires non-volatiles qui peuvent être internes ou externes audit dispositif 10 d'encodage. Le cas échéant, la ou les mémoires non-volatiles mémorisent également, de préférence, le produit programme de configuration utilisé pour configurer ledit FPGA.

Grâce à son architecture particulière, le dispositif 10 d'encodage comporte de nombreux trajets possibles pour les bits de données à encoder et/ou pour les bits de données encodées. Ainsi, des bits de données correspondant à des bits systématiques peuvent être envoyés de l'interface d'entrée 100 vers l'interface de sortie via les liaisons 104 et 105. Des bits de données à encoder peuvent être envoyés directement au troisième circuit d'encodage 108, via la liaison 104, sans passer par le premier circuit d'encodage 106 ou le second circuit d'encodage 107. Des bits de données encodées par le premier circuit d'encodage 106 et/ou par le second circuit d'encodage 107 peuvent être envoyés vers le troisième circuit d'encodage 108 ou vers l'interface de sortie 101 (via la liaison 105), etc.

En outre, de nombreux types particuliers de codes LDPC correspondent à des codes LDPC quasi-cycliques et/ou à des juxtapositions et/ou à des combinaisons de codes LDPC quasi-cycliques (SPC, IRA, ARA, etc.), et on comprend qu'une telle architecture de dispositif 10 d'encodage permet de former de nombreux types différents de codes LDPC, au moyen de configurations adaptées des trois circuits d'encodage 106, 107, 108.

Chacun des trois circuits d'encodage 106, 107, 108 de codes LDPC peut être configuré pour former différents codes LDPC, correspondant par exemple à des types différents de codes LDPC et/ou à des taux de codage différents pour un même type de code LDPC. Par exemple, il est possible de mémoriser plusieurs matrices d'encodage pour un même circuit d'encodage 106, 107, 108, qui pourront être utilisées à des instants différents, en fonction du code LDPC sélectionné et mis en oeuvre à un instant donné par le dispositif 10 d'encodage.

Un tel dispositif 10 d'encodage permet notamment de former les différents types de codes LDPC envisagés pour le standard défini par le CCSDS, qui comportent des codes LDPC ARA juxtaposant des codes LDPC IRA et SPC en parallèle, mais également des codes LDPC combinant des codes LDPC ARA et SPC en série.

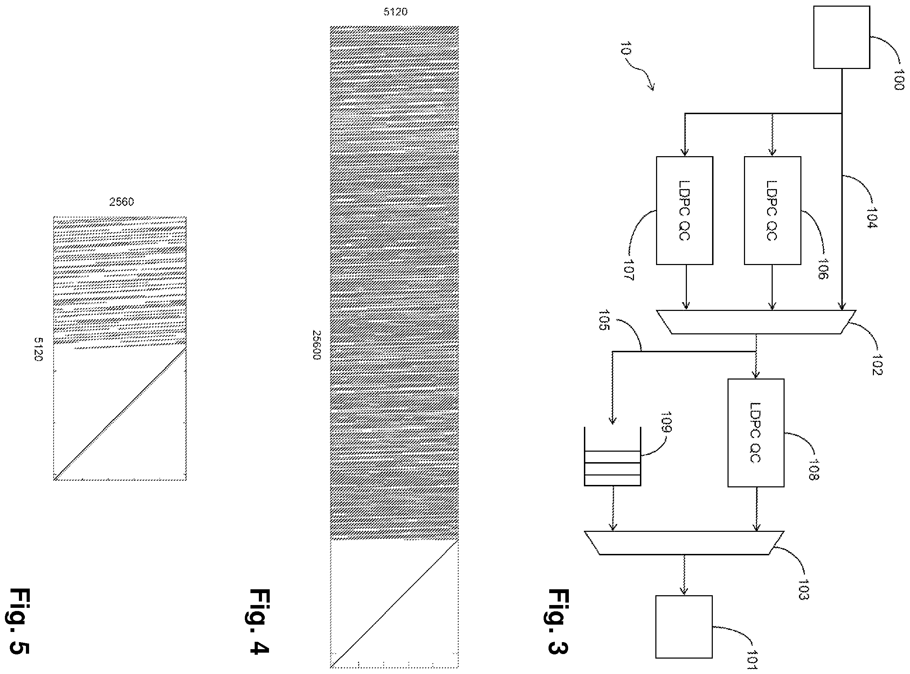

La figure 3 représente schématiquement un mode préféré de réalisation du dispositif 10 d'encodage. Tel qu'illustré par la figure 3, le dispositif 10 d'encodage comporte, outre les éléments décrits en référence à la figure 1, une mémoire tampon 109, par exemple de type FIFO, agencée sur la liaison 105 entre le premier circuit multiplexeur 102 et le second circuit multiplexeur 103. Grâce à cette mémoire tampon 109, l'écriture des mots de code LDPC sur l'interface de sortie 101 du dispositif d'encodage est plus efficace. En effet, il est possible de regrouper au fur et à mesure, dans la mémoire tampon 109, des bits de données encodées (bits systématiques et/ou bits de parité). Ainsi, les transferts de mémoire vers l'interface de sortie 101 peuvent être réalisés en transférant des blocs de bits de données encodées en mode rafale pour optimiser l'utilisation de la bande passante de l'interface de sortie (« burst accesses » dans la littérature anglo-saxonne).

Dans la suite de la description, on considère de manière non limitative que :

- le premier circuit d'encodage 106 est configuré pour former un ou plusieurs codes LDPC IRA ; à cet effet, les informations de configuration du premier circuit d'encodage 106 comportent au moins une matrice d'encodage de code LDPC IRA,
- le second circuit d'encodage 107 est configuré pour former un ou plusieurs codes LDPC SPC ; à cet effet, les informations de configuration du second circuit d'encodage 107 comportent au moins une matrice d'encodage de code LDPC SPC,
- le troisième circuit d'encodage 108 est configuré pour former un ou plusieurs codes LDPC SPC ; à cet effet, les informations de configuration du troisième circuit d'encodage 108 comportent au moins une matrice d'encodage de code LDPC SPC.

Avec une telle configuration des trois circuits d'encodage 106, 107, 108 de codes LDPC quasi-cycliques, le dispositif 10 d'encodage peut notamment encoder des codes LDPC dont la matrice de parité **H** peut être mise sous la forme suivante :

[Math. 1]

$$H = \begin{pmatrix} A & 0 & D & 0 \\ B & E & 0 & 0 \\ C' & C'' & C''' & F \end{pmatrix}$$

expression dans laquelle les matrices **E** et **F** sont des matrices diagonales (matrice identité), et la matrice **D** est une matrice à double diagonale (éventuellement incomplète en ce que les valeurs de la double diagonale ne sont pas nécessairement toutes non nulles, mais toutes les valeurs en dehors de la double diagonale sont nulles). Les matrices **A, B** et **C** = (**C' C'' C'''**) sont des matrices complétant les matrices respectivement **D, E** et **F** pour former des matrices de parité de codes LDPC quasi-cycliques. Une telle matrice de parité **H** correspond par exemple au cas d'un code LDPC combinant en série des codes LDPC SPC et ARA, le code ARA étant lui-même une juxtaposition de codes LDPC IRA et SPC en série. Dans des modes préférés de réalisation, la matrice **B** peut être mise sous la forme **B** = (**B' 0**) ou **B** = (**0 B'**), afin de limiter la quantité de calculs associés.

Avec une telle configuration des trois circuits d'encodage 106, 107, 108 de codes LDPC quasi-cycliques, le dispositif 10 d'encodage peut également encoder des codes LDPC dont la matrice de parité **H** peut être mise sous la forme suivante :

[Math. 2]

$$\mathbf{H} = \begin{pmatrix} \mathbf{A} & \mathbf{0} & \mathbf{D} \\ \mathbf{B} & \mathbf{E} & \mathbf{0} \end{pmatrix}$$

expression dans laquelle ce qui a dit en référence à l'expression [Math. 1] au sujet des matrices **A, B, D** et **E** est valable également pour l'expression [Math. 2], les matrices n'étant cependant pas nécessairement les mêmes. Une telle matrice de parité **H** correspond par exemple au cas d'un code LDPC ARA juxtaposant des codes LDPC IRA et SPC en série.

Avec une telle configuration des trois circuits d'encodage 106, 107, 108 de codes LDPC quasi-cycliques, le dispositif 10 d'encodage peut également encoder des codes LDPC dont la matrice de parité **H** peut être mise sous la forme suivante :

[Math. 3]

$$\mathbf{H} = \begin{pmatrix} \mathbf{A} & \mathbf{D} \end{pmatrix}$$

expression dans laquelle ce qui a dit en référence à l'expression [Math. 1] au sujet des matrices **A** et **D** est valable également pour l'expression [Math. 3], les matrices n'étant cependant pas nécessairement les mêmes. Une telle matrice de parité **H** correspond par exemple au cas d'un code LDPC IRA.

Les matrices de parité données par les expressions [Math. 1] et [Math. 2] sont avantageuses en ce qu'elles permettent d'effectuer un encodage simple des différents codes LPDC quasi-cycliques des trois circuits d'encodage 106, 107, 108. On décrit ci-après un exemple d'implémentation des différents codes LDPC quasi-cycliques dans le cas d'un code LDPC dont la matrice de parité peut être mise sous la forme donnée par l'expression [Math. 1], et en considérant en outre, à titre d'exemple, que **B** = (**B' 0**).

En pratique, on peut considérer que :

- la matrice $\mathbf{H}^{IRA}$ = (**A D**) correspond à la matrice de parité d'un code LDPC IRA,
- la matrice $\mathbf{H}^{SPC1}$ = (**B' E**) correspond à la matrice de parité d'un code LDPC SPC implémenté par le second circuit d'encodage 107, dit code LDPC SPC1,
- la matrice $\mathbf{H}^{SPC2}$ = (**C F**) correspond à la matrice de parité d'un code LDPC SPC implémenté par le troisième circuit d'encodage 108, dit code LDPC SPC2.

On considère que la matrice $\mathbf{H}^{IRA}$ est de dimensions $m_A \cdot Z \times n_A \cdot Z$, que la matrice $\mathbf{H}^{SPC1}$ est de dimensions $m_{B'} \cdot Z \times n_{B'} \cdot Z$ et que la matrice $\mathbf{H}^{SPC2}$ est de dimensions $m_C \cdot Z \times n_C \cdot Z$. Afin de faciliter l'implémentation, on transforme les matrices de parité $\mathbf{H}^{IRA}$, $\mathbf{H}^{SPC1}$ et $\mathbf{H}^{SPC2}$ au moyen d'un matrice de permutation $\Pi_X$ de dimensions $m_X \cdot Z \times m_X \cdot Z$ qui réalise un entrelacement lignes-colonnes tel que chaque ligne $m \cdot n_X + n$ d'une matrice $\mathbf{X} \in \{\mathbf{A}, \mathbf{B}, \mathbf{C}\}$ devient la ligne $n \cdot m_X + m$ dans la matrice $\Pi_X^T \cdot \mathbf{X}$. On peut calculer de la sorte des matrices $\mathbf{H}'^{IRA}$, $\mathbf{H}'^{SPC1}$ et $\mathbf{H}'^{SPC2}$ à utiliser pour l'encodage (compatibles avec la forme décrite dans [RiShUr]), telles que :

[Math. 4]

$$\mathbf{H'}^{IRA} = [\mathbf{\Pi}_A^T \cdot \mathbf{A} \mid \mathbf{\Pi}_A^T \cdot \mathbf{D} \cdot \mathbf{\Pi}_A]$$

$$\mathbf{H'}^{SPC1} = [\mathbf{\Pi}_{B\prime}^T \cdot \mathbf{B'} \mid \mathbf{\Pi}_{B\prime}^T \cdot \mathbf{E} \cdot \mathbf{\Pi}_{B\prime}]$$

$$\mathbf{H'}^{SPC2} = [\mathbf{\Pi}_C^T \cdot \mathbf{C} \mid \mathbf{\Pi}_C^T \cdot \mathbf{F} \cdot \mathbf{\Pi}_C]$$

Etant donné que les matrices E et F correspondent à la matrice identité, on a $\mathbf{\Pi}_{B\prime}^T \cdot \mathbf{E} \cdot \mathbf{\Pi}_{B\prime} = \mathbf{E}$ et $\mathbf{\Pi}_C^T \cdot \mathbf{F} \cdot \mathbf{\Pi}_C = \mathbf{F}$.

On désigne par u le vecteur ligne de bits de données à encoder, et par **p** le vecteur ligne de bits de parité. D'après la forme de la matrice de parité **H** donnée par l'expression [Math. 1], on constate que le vecteur **p** peut être décomposé comme suit :

[Math. 5]

$$\mathbf{p} = [\mathbf{p}^{SPC1} \mid \mathbf{p}^{IRA} \mid \mathbf{p}^{SPC2}]$$

Également, on constate d'après la forme de la matrice **B = (B' 0)** que le code LPDC SPC1 ne prend en compte qu'une partie des bits de données à encoder, de sorte qu'il est possible de décomposer le vecteur **u** comme suit :

[Math. 6]

$$\mathbf{u} = [\mathbf{u}^{SPC1} \mid \mathbf{u'}]$$

expression dans laquelle les vecteur **u**$^{SPC1}$ comprend les bits de données à encoder qui sont utilisés par le code LDPC SPC1.

En désignant par **y**$^{SPC1}$ = [**u**$^{SPC1}$ | **p**$^{SPC1}$], et étant donné que :

[Math. 7]

$$\mathbf{H'}^{SPC1} \cdot (\mathbf{y}^{SPC1})^T = \mathbf{0}$$

alors on en déduit que les bits de parité **p**$^{SPC1}$ peuvent être obtenus en calculant l'expression suivante :

[Math. 8]

$$\mathbf{p}^{SPC1} = \mathbf{\Pi}_{B\prime}^T \cdot \mathbf{B'} \cdot (\mathbf{u}^{SPC1})^T$$

En désignant par *u*$^{IRA}$ le vecteur ligne comprenant les bits du vecteur u qui sont utilisés par le code LDPC IRA, alors l'encodage du code LDPC IRA, pour obtenir le vecteur **p**$^{IRA}$, peut être réalisé de manière conventionnelle selon l'expression suivante :

[Math. 9]

$$p_l^{IRA} = \sum_{j=1}^{n_A - m_A} H'^{IRA}_{l,j} \cdot u_j^{IRA} + \sum_{j=1}^{l-1} H'^{IRA}_{l,j+n_A - m_A} \cdot p_j^{IRA}$$

Une fois que les vecteurs **p**$^{SPC1}$ et **p**$^{IRA}$ ont été calculés, les bits de données fournis en entrée du code LDPC SPC2 (troisième circuit d'encodage 108) correspondent à un vecteur $\mathbf{u}^{SPC2} = [\mathbf{u} \mid \mathbf{p}^{SPC1} \mid \mathbf{p}^{IRA}]$. Etant donné que la matrice F correspond à la matrice identité, le vecteur $\mathbf{p}^{SPC2}$ peut être calculé selon l'expression suivante :

[Math. 10]

$$\mathbf{p}^{SPC2} = \mathbf{\Pi}_C^T \cdot \mathbf{C} \cdot (\mathbf{u}^{SPC2})^T$$

Le mot de code LDPC final formé, désigné par $\mathbf{y}^{LDPC}$, est par exemple donné par l'expression suivante :

[Math. 11]

$$\mathbf{y}^{LDPC} = [\mathbf{u} \mid \mathbf{p}^{SPC1} \mid \mathbf{p}^{IRA} \mid \mathbf{p}^{SPC2}]$$

Les figures 4, 5 et 6 montrent des matrices $\mathbf{H}^{'IRA}$, $\mathbf{H}^{'SPC1}$ et $\mathbf{H}^{'SPC2}$ pouvant être mémorisées en tant que matrices d'encodage pour encoder un code LDPC combinant des codes LDPC ARA et SPC en série, le code LDPC ARA étant lui-même obtenu par la juxtaposition de codes LDPC IRA et SPC en parallèle. Dans ces figures, les zones en noir correspondent à des valeurs non nulles, tandis que les zones en blanc correspondent à des valeurs nulles.

Dans l'exemple illustré par les figures 4 à 6, le code LPDC obtenu présente un taux de codage égal à 2/3, et une taille de mots de code égale à 30720 bits (obtenus à partir d'un paquet de données comportant 20480 bits de données à encoder). Plus particulièrement :

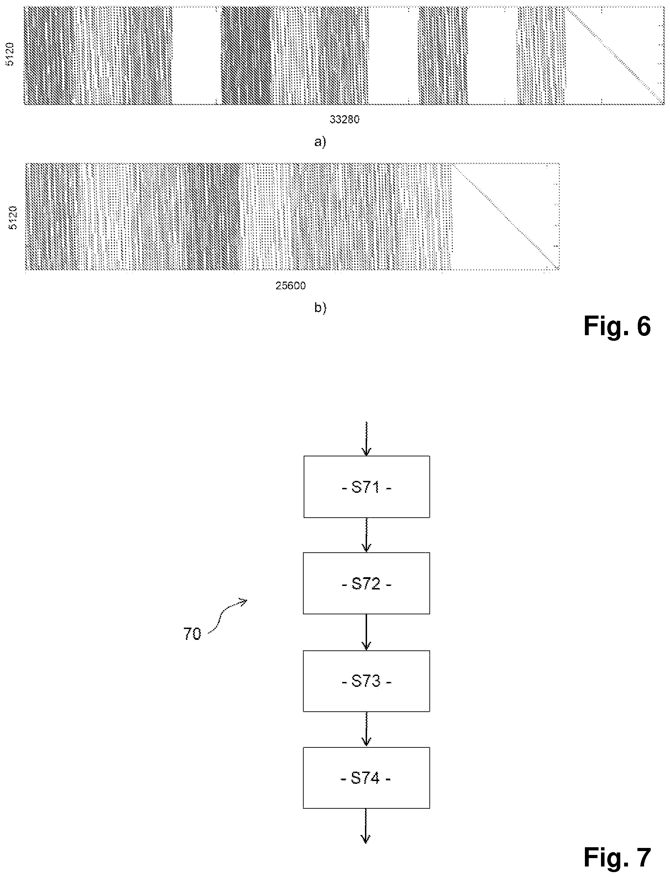

- la figure 4 représente schématiquement un exemple de matrice $\mathbf{H}^{'IRA}$ de dimensions 5120 × 25600,
- la figure 5 représente schématiquement un exemple de matrice $\mathbf{H}^{'SPC1}$ de dimensions 2560 × 5120,
- la partie a) de la figure 6 représente schématiquement un exemple de matrice $\mathbf{H}^{'SPC2}$ de dimensions 5120 × 33280 ; toutefois, on constate que cette matrice $\mathbf{H}^{'SPC2}$ comporte de nombreuses colonnes adjacentes constituées de valeurs nulles ; de préférence, les colonnes adjacentes (ou les lignes adjacentes si l'on considère par exemple la matrice transposée) constituées de valeurs nulles ne sont pas mémorisées afin de réduire l'empreinte mémoire et d'accélérer l'encodage, et la partie b) de la figure 6 représente la matrice $\mathbf{H}^{'SPC2}$ mémorisée, de dimensions 5120 × 25600.

La figure 7 représente les principales étapes d'un procédé 70 d'encodage dans le cas d'un code LDPC nécessitant d'utiliser les trois circuits d'encodage 106, 107, 108, le premier circuit d'encodage 106 et le second circuit d'encodage 107 étant utilisés en parallèle entre eux, et en série avec le troisième circuit d'encodage 108.

Tel qu'illustré par la figure 7, le procédé 70 d'encodage comporte notamment :

- une étape S71 d'écriture en parallèle de données d'un paquet de données à encoder dans des mémoires tampons d'entrée respectives du premier circuit d'encodage 106, du second circuit d'encodage 107 et du troisième circuit d'encodage 108,
- une étape S72 d'encodage en parallèle des données en mémoire tampon d'entrée par le premier circuit d'encodage 106 et le second circuit d'encodage 107,
- une étape S73 d'écriture de données encodées par respectivement le premier circuit d'encodage 106 et le second circuit d'encodage 107 dans la mémoire tampon d'entrée du troisième circuit d'encodage 108,
- une étape S74 d'encodage des données en mémoire tampon d'entrée par le troisième circuit d'encodage 108.

Outre ces étapes principales, d'autres étapes peuvent être mises en oeuvre, par exemple pour écrire les bits systématiques dans la mémoire tampon 109 (ou directement sur l'interface de sortie 101 dans le cas du dispositif 10 d'encodage de la figure 1), et/ou pour écrire des bits de parité fournis par le premier circuit d'encodage 106 et/ou par le second circuit d'encodage 107, à inclure dans le mot de code LDPC, dans la mémoire tampon 109 (ou directement sur l'interface de sortie 101).

On décrit à présent un exemple de mise en oeuvre du procédé 70 d'encodage, dans le cas du dispositif d'encodage de la figure 3, pour encoder un code LDPC combinant des codes LDPC ARA et SPC en série, le code LDPC ARA étant lui-même obtenu par la juxtaposition de codes LDPC IRA et SPC en parallèle. Dans cet exemple, on considère de manière non limitative le cas où le code LPDC obtenu présente un taux de codage égal à 2/3, et une taille de mots de code égale à 30720 bits (obtenus à partir d'un paquet de données comportant 20480 bits de données à encoder), utilisant par exemple les matrices $\mathbf{H}^{'IRA}$, $\mathbf{H}^{'SPC1}$ et $\mathbf{H}^{'SPC2}$ représentées sur les figures 4 à 6.

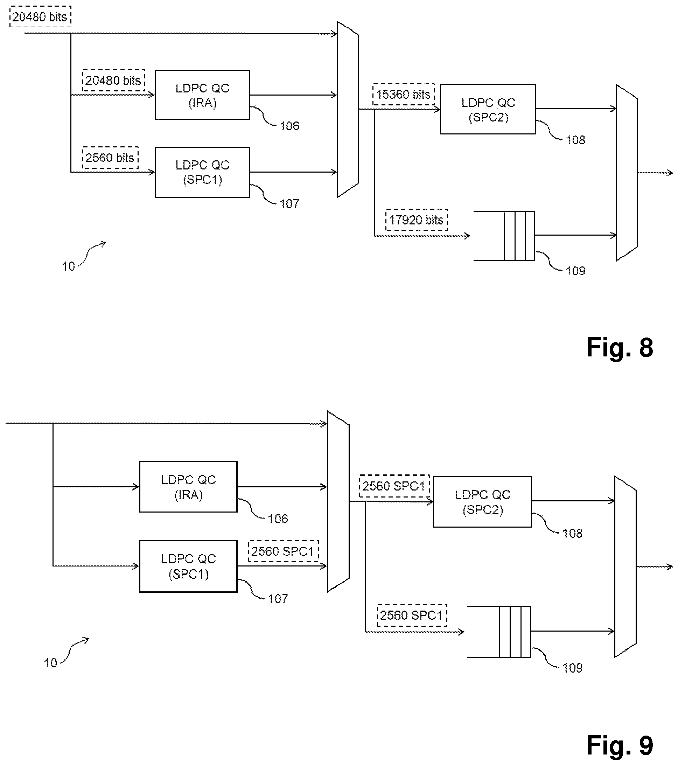

La figure 8 illustre l'étape S71 d'écriture. Tel qu'illustré par la figure 8, les 20480 bits de données à encoder sont écrits dans la mémoire tampon d'entrée du premier circuit d'encodage 106. Seuls 2560 bits de données à encoder sont écrits dans la mémoire tampon d'entrée du second circuit d'encodage 107, et seuls 15360 bits de données à encoder sont écrits dans la mémoire tampon d'entrée du troisième circuit d'encodage 108. En outre, les bits systématiques, au nombre de 17920 après poinçonnage, sont écrits dans la mémoire tampon 109 entre le premier circuit multiplexeur 102 et le second circuit multiplexeur 103.

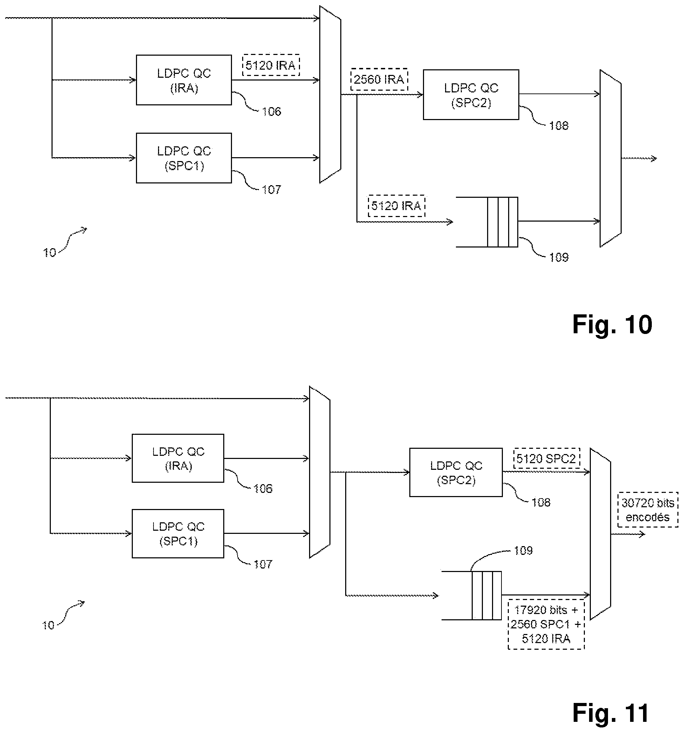

Les figures 9 et 10 illustrent l'étape S72 d'encodage et S73 d'écriture dans la mémoire tampon d'entrée du troisième circuit d'encodage 108. Tel qu'illustré par la figure 9, l'encodage par le second circuit d'encodage 107 s'achève en premier, et produit 2560 bits de parité, désignés par SPC1. Les 2560 bits de parité SPC1 sont écrits à la fois dans la mémoire tampon d'entrée du troisième circuit d'encodage 108 et dans la mémoire tampon 109 entre le premier circuit multiplexeur 102 et le second circuit multiplexeur 103, à la suite des 17920 bits systématiques. Tel qu'illustré par la figure 10, l'encodage par le premier circuit d'encodage 106 s'achève en second, et produit 5120 bits de parité, désignés par IRA. Seuls 2560 bits de parité IRA sont écrits dans la mémoire tampon d'entrée du troisième circuit d'encodage 108. Les 5120 bits de parité IRA sont écrits dans la mémoire tampon 109 entre le premier circuit multiplexeur 102 et le second circuit multiplexeur 103, à la suite des 2560 bits de parité SPC1.

La figure 11 illustre l'étape S74 d'encodage par le troisième circuit d'encodage 108. Tel qu'illustré par la figure 11, l'encodage par le troisième circuit d'encodage 108 produit 5120 bits de parité, désignés par SPC2, à partir des 15360 bits de données, des 2560 bits de parité SPC1 et des 2560 bits de parité IRA mémorisés dans la mémoire tampon d'entrée dudit troisième circuit d'encodage 108. A l'issue de l'étape S74 d'encodage par le troisième circuit d'encodage 108, le mot de code LDPC généré peut être fourni sur l'interface de sortie 101, en écrivant sur celle-ci les bits systématiques (17920), les bits de parité SPC1 (2560) et les bits de parité IRA (5120) mémorisés dans la mémoire tampon 109, puis les bits de parité SPC2 (5120) fournis par le troisième circuit d'encodage 108, formant ainsi le mot de code LDPC final comportant 30720 bits de données encodées.

Ainsi, le dispositif 10 d'encodage proposé permet d'optimiser les traitements, notamment par la possibilité de réaliser de nombreux accès en écriture en parallèle (dans les mémoires tampons d'entrée respectives des trois circuits d'encodage 106, 107, 108, et éventuellement dans la mémoire tampon 109), mais également par le fait que certains traitements d'encodage sont réalisés en parallèle (par les premier et second circuits d'encodage 106, 107).

Dans des modes préférés de réalisation du dispositif 10 d'encodage, la mémoire tampon d'entrée du troisième circuit d'encodage 108 est de taille adaptée à mémoriser des données correspondant à au moins deux paquets de données à encoder. Dans le cas du dispositif 10 d'encodage de la figure 3, la mémoire tampon 109 entre le premier circuit multiplexeur 102 et le second circuit multiplexeur 103 est également de taille adaptée à mémoriser des données correspondant à au moins deux paquets de données à encoder. De telles dispositions sont avantageuses en ce qu'elles permettent en outre de paralléliser les traitements d'encodage réalisés par le troisième circuit d'encodage 108 avec ceux réalisés par les premier et second circuits d'encodage 106, 107. En effet, après que les bits de données encodées par les premier et second circuits d'encodage 106, 107 ont été écrits dans la mémoire tampon d'entrée du troisième circuit d'encodage 108 (et dans la mémoire tampon 109), les bits de données d'un nouveau paquet de données à encoder peuvent être écrits dans les mémoires tampons d'entrée des trois circuits d'encodage 106, 107, 108, et peuvent commencer à être encodés par les premier et second circuits d'encodage 106, 107 avant que le troisième circuit d'encodage 108 n'ait fini d'encoder les bits de données du paquet de données précédent.

Ce qui a été décrit en référence aux figures 7 à 11 correspond à une utilisation avantageuse du dispositif 10 d'encodage dans le cas de la mise en oeuvre d'un code LDPC utilisant les trois circuits d'encodage 106, 107, 108, qui correspond au cas le plus contraignant pour obtenir des débits de transmission élevés. Dans le cas où le code LDPC considéré ne requiert pas d'utiliser le troisième circuit d'encodage 108, par exemple pour encoder un code LDPC ARA (au moyen d'une juxtaposition de codes LDPC IRA et SPC en parallèle), il est possible d'écrire directement les bits de parité SPC1 et les bits de parité IRA à la suite des bits systématiques dans la mémoire tampon 109 (ou directement dans l'interface de sortie 101 dans le cas du dispositif 10 d'encodage de la figure 1), sans utiliser le troisième circuit d'encodage 108. Il est également possible d'encoder un code LDPC IRA en écrivant directement les bits de parité IRA à la suite des bits systématiques dans la mémoire tampon 109 (ou directement dans l'interface de sortie 101), sans utiliser le second circuit d'encodage 107 et sans utiliser le troisième circuit d'encodage 108, etc.

Par ses différentes caractéristiques et leurs avantages, le dispositif 10 d'encodage atteint les objectifs fixés. En particulier, le dispositif 10 d'encodage peut encoder de manière flexible différents codes LDPC, en utilisant des configurations différentes, notamment pour les trois circuits d'encodage 106, 107, 108 de codes LDPC quasi-cycliques. En outre, le dispositif 10 d'encodage proposé est compatible avec des débits de transmission élevés, de l'ordre de 10 Gbits/s. En particulier, les inventeurs ont implémenté les codes LDPC proposés pour le standard défini par le CCSDS sur un circuit logique programmable FPGA Xilinx® KU060, et ont constaté que le débit de transmission attendu (10 Gbps/s) était atteint en utilisant une fréquence d'horloge de 400 MHz, en implémentant sur le FPGA un seul dispositif 10 d'encodage tel que décrit en référence à la figure 3. En utilisant une fréquence d'horloge de 200 MHz, le débit de transmission de 10 Gbps est atteint en implémentant deux dispositifs 10 d'encodage sur le même FPGA Xilinx® KU060, lesquels deux dispositif 10 d'encodage effectuent des traitements en parallèle. L'implémentation de deux dispositifs 10 d'encodage sur un même FPGA Xilinx® KU060 nécessite moins de 5% des ressources dudit FPGA Xilinx® KU060.

Le dispositif 10 d'encodage proposé peut être mis en oeuvre pour encoder des données à bord d'un satellite, et les données encodées peuvent être transmises à une station sol ou à un autre satellite. Les données encodées peuvent être transmises via une liaison optique (en particulier pour un débit de transmission de 10 Gbps/s) ou via une liaison radioélectrique (dans le cas de débits de transmission inférieurs, par exemple de l'ordre de 1 Gbps/s).

De manière plus générale, il est à noter que les modes de mise en oeuvre et de réalisation considérés ci-dessus ont été décrits à titre d'exemples non limitatifs, et que d'autres variantes sont par conséquent envisageables.

Notamment, l'invention a été décrite en considérant principalement un dispositif 10 d'encodage à embarquer dans un satellite en orbite terrestre. Rien n'exclut cependant, suivant d'autres exemples, d'utiliser le dispositif 10 d'encodage dans des systèmes de communication terrestre.

En outre, l'invention a été décrite en considérant principalement un dispositif 10 d'encodage comportant trois circuits d'encodage 106, 107, 108 de codes LDPC quasi-cycliques. Rien n'exclut cependant, suivant d'autres exemples, de considérer un nombre plus important de circuits d'encodage de codes LDPC quasi-cycliques. Toutefois, un dispositif 10 d'encodage comportant exactement trois circuits d'encodage 106, 107, 108 de codes LDPC quasi-cycliques correspond à un mode préféré de réalisation, avantageux notamment d'un point de vue compromis entre flexibilité offerte (forte) et l'empreinte mémoire associé (limitée).

**Références**

[Mohanad] Alfiras Mohanad et al., « Hybrid concatenated LDPC codes with LTE modulation schemes », International Journal of Advanced Computer Science and Applications, volume 10, N° 5, 2019.

[Koller] Christian Koller et al., « Hybrid concatenated codes with asymptotically good distance growth », IEEE Proceedings 5th International Symposium on Turbo Codes and Related Topics, pages 19-24, 2008.

[Zhang] Yifei Zhang et al., « Structured eIRA codes with low floors », Proceedings International Symposium on Information Theory, pages 174-178, Adélaïde, 2005.

[Dimitris] Theodoropoulos Dimitris et al., « Efficient Architectures for Multigigabit CCSDS LDPC Encoders », IEEE Transactions on Very Large Scale Integration Systems, volume 28, N° 5, pages 1118-1127, 2020.

[Chen] Liang Chen et al., « Implementation of multi-rate quasi-cyclic low-density parity-check codes », The 9th International Conférence on Advanced Communication Technology, volume 2, pages 1066-1070, 2007.

[Foss] M. P. C. Fossorier, « Quasicyclic low-density parity-check codes from circulant permutation matrices », IEEE Transactions on Information Theory, volume 50, N° 8, pages 1788-1793, Août 2004.

[RiShUr] T. J. Richardson, M. A. Shokrollahi et R. L. Urbanke, « Design of capacity-approaching irregular low-density parity-check codes », IEEE Transactions on Information Theory, volume 47, N° 2, pages 619-637, Février 2001.

**Revendications**

1. Dispositif (10) d'encodage de données adapté à encoder une pluralité de codes à contrôle de parité à faible densité, dits codes LDPC, ledit dispositif d'encodage comportant une interface d'entrée (100) pour recevoir des données d'un paquet de données à encoder et une interface de sortie (101) pour fournir des données encodées, **caractérisé en ce qu'**il comporte :

    - un premier circuit multiplexeur (102) et un second circuit multiplexeur (103), ledit premier circuit multiplexeur étant relié en entrée à l'interface d'entrée et en sortie à l'entrée dudit second circuit multiplexeur, ledit second circuit multiplexeur étant relié en sortie à l'interface de sortie,
    - un premier circuit d'encodage (106) de code LDPC quasi-cyclique, relié en entrée à l'interface d'entrée (100) et en sortie à l'entrée du premier circuit multiplexeur (102),
    - un second circuit d'encodage (107) de code LDPC quasi-cyclique, relié en entrée à l'interface d'entrée (100) et en sortie à l'entrée du premier circuit multiplexeur (102), ledit second circuit d'encodage (107) étant agencé en parallèle avec ledit premier circuit d'encodage (106),
    - un troisième circuit d'encodage (108) de code LDPC quasi-cyclique, relié en entrée à la sortie du premier circuit multiplexeur (102) et en sortie à l'entrée du second circuit multiplexeur (103).

2. Dispositif (10) d'encodage selon la revendication 1, comportant au moins une mémoire dans laquelle sont mémorisées des informations de configuration comportant :

- au moins une matrice d'encodage de code LDPC à répétition irrégulière-accumulation, dit code LDPC IRA, pour configurer le premier circuit d'encodage (106),
- au moins une matrice d'encodage de code LDPC à simple contrôle de parité, dit code LDPC SPC, pour configurer le second circuit d'encodage (107),
- au moins une matrice d'encodage de code LDPC SPC pour configurer le troisième circuit d'encodage (108).

3. Dispositif (10) d'encodage selon la revendication 2, dans lequel au moins une matrice d'encodage de code LDPC est mémorisée partiellement, des lignes ou colonnes adjacentes de ladite matrice d'encodage de code LDPC qui sont constituées de valeurs nulles n'étant pas mémorisées.

4. Dispositif (10) d'encodage selon l'une quelconque des revendications précédentes, dans lequel le troisième circuit d'encodage (108) comporte une mémoire tampon d'entrée de taille adaptée à mémoriser des données correspondant à au moins deux paquets de données à encoder.

5. Dispositif (10) d'encodage selon l'une quelconque des revendications précédentes, dans lequel le premier circuit multiplexeur (102) est relié au second circuit multiplexeur (103) par l'intermédiaire d'une mémoire tampon.

6. Dispositif (10) d'encodage selon la revendication 5, dans lequel la mémoire tampon entre le premier circuit multiplexeur (102) et le second circuit multiplexeur (103) est de taille adaptée à mémoriser des données correspondant à au moins deux paquets de données à encoder.

7. Dispositif (10) d'encodage selon l'une quelconque des revendications précédentes, configuré pour encoder des codes LDPC dont la matrice de parité H peut être mise sous la forme suivante :

$$H = \begin{pmatrix} A & 0 & D \\ B & E & 0 \end{pmatrix}$$

ou selon la forme suivante :

$$H = \begin{pmatrix} A & 0 & D & 0 \\ B & E & 0 & 0 \\ C' & C'' & C''' & F \end{pmatrix}$$

expressions dans lesquelles les matrices E et F sont des matrices diagonales, et la matrice D est une matrice à double diagonale.

8. Dispositif (10) d'encodage selon l'une quelconque des revendications 1 à 6, configuré pour encoder des codes LDPC dont la matrice de parité H peut être mise sous la forme suivante :

$$H = \begin{pmatrix} A & D \end{pmatrix}$$

expression dans laquelle la matrice **D** est une matrice à double diagonale.

9. Satellite **caractérisé en ce qu'**il comporte un dispositif (10) d'encodage selon l'une quelconque des revendications précédentes.

10. Satellite selon la revendication 9, dans lequel les données encodées sont transmises sur une liaison optique.

11. Satellite selon la revendication 9 ou 10, dans lequel les données encodées sont transmises à un débit supérieur à 5 Gbits/s.

12. Procédé (70) d'encodage de codes à contrôle de parité à faible densité, dits codes LDPC, au moyen d'un dispositif (10) d'encodage selon l'une quelconque des revendications 1 à 8, comportant :

- une écriture (S71) en parallèle de données d'un paquet de données à encoder dans des mémoires tampons d'entrée respectives du premier circuit d'encodage (106), du second circuit d'encodage (107) et du troisième circuit d'encodage (108),
- un encodage (S72) en parallèle des données en mémoire tampon d'entrée par le premier circuit d'encodage (106) et le second circuit d'encodage (107),
- une écriture (S73) de données encodées par respectivement le premier circuit d'encodage (106) et/ou le second circuit d'encodage (107) dans la mémoire tampon d'entrée du troisième circuit d'encodage (108),
- un encodage (S74) des données en mémoire tampon d'entrée par le troisième circuit d'encodage (108).

**13.** Procédé (70) d'encodage selon la revendication 12, comportant, en parallèle de l'encodage (S74) par le troisième circuit d'encodage (108), une écriture en parallèle de données d'un autre paquet de données à encoder dans les mémoires tampons d'entrée respectives du premier circuit d'encodage, du second circuit d'encodage et du troisième circuit d'encodage.

**14.** Procédé (70) d'encodage selon la revendication 12 ou 13, dans lequel, le dispositif (10) d'encodage comportant une mémoire tampon entre le premier circuit multiplexeur (102) et le second circuit multiplexeur (103), les données du paquet de données sont écrites dans ladite mémoire tampon en parallèle de l'écriture dans les mémoires tampons d'entrée respectives du premier circuit d'encodage (106), du second circuit d'encodage (107) et du troisième circuit d'encodage (108).

**15.** Produit programme de configuration comportant des instructions qui, lorsqu'elles sont mises en oeuvre par un ordinateur pour configurer un circuit logique programmable, configurent ledit circuit logique programmable pour former un dispositif (10) d'encodage selon l'une quelconque des revendications 1 à 8.


**Patentansprüche**

**1.** Vorrichtung (10) zur Codierung von Daten, die dazu angepasst ist, eine Vielzahl von Low-Density-Parity-Check-Codes, LDPC-Codes, zu codieren, wobei die Codiervorrichtung eine Eingangsschnittstelle (100), um Daten eines zu codierenden Datenpakets zu empfangen, und eine Ausgangsschnittstelle (101), um codierte Daten bereitzustellen, umfasst, **dadurch gekennzeichnet, dass** sie Folgendes umfasst:

- eine erste Multiplexerschaltung (102) und eine zweite Multiplexerschaltung (103), wobei die erste Multiplexerschaltung eingangsseitig mit der Eingangsschnittstelle und ausgangsseitig mit dem Eingang der zweiten Multiplexerschaltung verbunden ist, wobei die zweite Multiplexerschaltung ausgangsseitig mit der Ausgangsschnittstelle verbunden ist,
- eine erste Codierschaltung (106) für einen quasi-zyklischen LDPC-Code, die eingangsseitig mit der Eingangsschnittstelle (100) und ausgangsseitig mit dem Eingang der ersten Multiplexerschaltung (102) verbunden ist,
- eine zweite Codierschaltung (107) für einen quasi-zyklischen LDPC-Code, die eingangsseitig mit der Eingangsschnittstelle (100) und ausgangsseitig mit dem Eingang der ersten Multiplexerschaltung (102) verbunden ist, wobei die zweite Codierschaltung (107) parallel zu der ersten Codierschaltung (106) eingerichtet ist,
- eine dritte Codierschaltung (108) für einen quasi-zyklischen LDPC-Code, die eingangsseitig mit dem Ausgang der ersten Multiplexerschaltung (102) und ausgangsseitig mit dem Eingang der zweiten Multiplexerschaltung (103) verbunden ist.

**2.** Codiervorrichtung (10) nach Anspruch 1, die mindestens einen Speicher umfasst, in dem Konfigurationsinformationen gespeichert sind, die Folgendes umfassen:

- mindestens eine Codiermatrix für einen Irregular-Repeat-Accumulate-LDPC-Code, IRA-LDPC-Code, um die erste Codierschaltung (106) zu konfigurieren,
- mindestens eine Codiermatrix für einen Single-Parity-Check-LDPC-Code, SPC-LDPC-Code, um die zweite Codierschaltung (107) zu konfigurieren,
- mindestens eine Codiermatrix für einen SPC-LDPC-Code, um die dritte Codierschaltung (108) zu konfigurieren.

**3.** Codiervorrichtung (10) nach Anspruch 2, wobei mindestens eine Codiermatrix für einen LDPC-Code teilweise gespeichert wird, wobei benachbarte Zeilen oder Spalten der Codiermatrix für einen LDPC-Code, die aus Nullwerten bestehen, nicht gespeichert werden.

**4.** Codiervorrichtung (10) nach einem beliebigen der vorhergehenden Ansprüche, wobei die dritte Codierschaltung (108) einen Eingangspufferspeicher umfasst, dessen Größe dazu angepasst ist, Daten, die mindestens zwei zu codierenden Datenpaketen entsprechen, zu speichern.

5. Codiervorrichtung (10) nach einem beliebigen der vorhergehenden Ansprüche, wobei die erste Multiplexerschaltung (102) über einen Pufferspeicher mit der zweiten Multiplexerschaltung (103) verbunden ist.

6. Codiervorrichtung (10) nach Anspruch 5, wobei der Pufferspeicher zwischen der ersten Multiplexerschaltung (102) und der zweiten Multiplexerschaltung (103) eine Größe aufweist, die dazu angepasst ist, Daten, die mindestens zwei zu codierenden Datenpaketen entsprechen, zu speichern.

7. Codiervorrichtung (10) nach einem beliebigen der vorhergehenden Ansprüche, die dazu konfiguriert ist, LDPC-Codes zu codieren, deren Paritätsmatrix H in die folgende Form gebracht werden kann:

$$H = \begin{pmatrix} A & 0 & D \\ B & E & 0 \end{pmatrix}$$

oder in die folgende Form gebracht werden kann:

$$H = \begin{pmatrix} A & 0 & D & 0 \\ B & E & 0 & 0 \\ C' & C'' & C''' & F \end{pmatrix}$$

wobei in diesen Ausdrücken die Matrizen E und F Diagonalmatrizen sind und die Matrix D eine Doppeldiagonalmatrix ist.

8. Codiervorrichtung (10) nach einem beliebigen der Ansprüche 1 bis 6, die dazu konfiguriert ist, LDPC-Codes zu codieren, deren Paritätsmatrix H in die folgende Form gebracht werden kann:

$$H = \begin{pmatrix} A & D \end{pmatrix}$$

wobei in diesem Ausdruck die Matrix D eine Doppeldiagonalmatrix ist.

9. Satellit, **dadurch gekennzeichnet, dass** er eine Codiervorrichtung (10) nach einem beliebigen der vorhergehenden Ansprüche umfasst.

10. Satellit nach Anspruch 9, wobei die codierten Daten über eine optische Verbindung übertragen werden.

11. Satellit nach Anspruch 9 oder 10, wobei die codierten Daten mit einer Rate von mehr als 5 Gbit/s übertragen werden.

12. Verfahren (70) zur Codierung von Low-Density-Parity-Check-Codes, LDPC-Codes, mittels einer Codiervorrichtung (10) nach einem beliebigen der Ansprüche 1 bis 8, umfassend:

   - paralleles Schreiben (S71) von Daten eines zu codierenden Datenpakets in Eingangspufferspeicher der ersten Codierschaltung (106), der zweiten Codierschaltung (107) bzw. der dritten Codierschaltung (108),
   - paralleles Codieren (S72) der Daten im Eingangspufferspeicher durch die erste Codierschaltung (106) und die zweite Codierschaltung (107),
   - Schreiben (S73) von Daten, die durch die erste Codierschaltung (106) und/oder die zweite Codierschaltung (107) codiert wurden, in den Eingangspufferspeicher der dritten Codierschaltung (108),
   - Codieren (S74) der Daten im Eingangspufferspeicher durch die dritte Codierschaltung (108).

13. Codierverfahren (70) nach Anspruch 12, das parallel zum Codieren (S74) durch die dritte Codierschaltung (108) ein paralleles Schreiben von Daten eines anderen zu codierenden Datenpakets in die Eingangspufferspeicher der ersten Codierschaltung, der zweiten Codierschaltung bzw. der dritten Codierschaltung umfasst.

14. Codierverfahren (70) nach Anspruch 12 oder 13, wobei, da die Codiervorrichtung (10) einen Pufferspeicher zwischen der ersten Multiplexerschaltung (102) und der zweiten Multiplexerschaltung (103) umfasst, die Daten des Datenpakets parallel zu dem Schreiben in die Eingangspufferspeicher der ersten Codierschaltung (106), der zweiten Codierschaltung (107) bzw. der dritten Codierschaltung (108) in den Pufferspeicher geschrieben werden.

**15.** Konfigurationsprogrammprodukt, das Anweisungen umfasst, die, wenn sie durch einen Computer umgesetzt werden, um eine programmierbare Logikschaltung zu konfigurieren, die programmierbare Logikschaltung dazu konfigurieren, eine Codiervorrichtung (10) nach einem beliebigen der Ansprüche 1 bis 8 zu bilden.

**Claims**

**1.** Data encoding device (10) suitable for encoding a plurality of low-density parity-check codes, referred to as LDPC codes, said encoding device comprising an input interface (100) for receiving data of a data packet to be encoded and an output interface (101) for providing encoded data, **characterized in that** it comprises:

- a first multiplexer circuit (102) and a second multiplexer circuit (103), said first multiplexer circuit being connected at an input to the input interface and at an output to the input of said second multiplexer circuit, said second multiplexer circuit being connected at an output to the output interface,
- a first encoding circuit (106) for encoding quasi-cyclic LDPC code, connected at an input to the input interface (100) and at an output to the input of the first multiplexer circuit (102),
- a second encoding circuit (107) for encoding quasi-cyclic LDPC code, connected at an input to the input interface (100) and at an output to the input of the first multiplexer circuit (102), said second encoding circuit (107) being arranged in parallel with said first encoding circuit (106),
- a third encoding circuit (108) for encoding quasi-cyclic LDPC code, connected at an input to the output of the first multiplexer circuit (102) and at an output to the input of the second multiplexer circuit (103).

**2.** Encoding device (10) according to claim 1, comprising at least one memory in which is stored configuration information comprising:

- at least one encoding matrix for LDPC code with irregular repetition-accumulation, referred to as LDPC IRA code, for configuring the first encoding circuit (106),
- at least one encoding matrix for LDPC code with simple parity check, referred to as LDPC SPC code, for configuring the second encoding circuit (107),
- at least one encoding matrix for LDPC SPC code, for configuring the third encoding circuit (108).

**3.** Encoding device (10) according to claim 2, wherein at least one encoding matrix for LDPC code is partially stored, by not storing adjacent rows or columns of said encoding matrix for LDPC code which consist of zero values.

**4.** Encoding device (10) according to any one of the preceding claims, wherein the third encoding circuit (108) comprises an input buffer of a size suitable for storing data corresponding to at least two data packets to be encoded.

**5.** Encoding device (10) according to any one of the preceding claims, wherein the first multiplexer circuit (102) is connected to the second multiplexer circuit (103) via a buffer memory.

**6.** Encoding device (10) according to claim 5, wherein the buffer memory between the first multiplexer circuit (102) and the second multiplexer circuit (103) is of a size suitable for storing data corresponding to at least two data packets to be encoded.

**7.** Encoding device (10) according to any one of the preceding claims, configured to encode LDPC codes whose parity matrix H can be put in the following form:

$$H = \begin{pmatrix} A & 0 & D \\ B & E & 0 \end{pmatrix}$$

or in the following form:

$$H = \begin{pmatrix} A & 0 & D & 0 \\ B & E & 0 & 0 \\ C' & C'' & C''' & F \end{pmatrix}$$

expressions in which matrices E and F are diagonal matrices, and matrix D is a dual diagonal matrix.

8. Encoding device (10) according to any one of claims 1 to 6, configured to encode LDPC codes whose parity matrix H can be put in the following form:

$$H = (A \quad D)$$

expression in which matrix D is a dual diagonal matrix.

9. Satellite **characterized in that** it comprises an encoding device (10) according to any one of the preceding claims.

10. Satellite according to claim 9, wherein the encoded data are transmitted over an optical link.

11. Satellite according to claim 9 or 10, wherein the encoded data are transmitted at a rate greater than 5 Gbit/s.

12. Method (70) for encoding low-density parity-check codes, referred to as LDPC codes, by means of an encoding device (10) according to any one of claims 1 to 8, comprising :

   - writing (S71), in parallel, data of a data packet to be encoded, into respective input buffer memories of the first encoding circuit (106), second encoding circuit (107), and third encoding circuit (108),
   - encoding (S72), in parallel, data in the input buffer memory, by the first encoding circuit (106) and the second encoding circuit (107),
   - writing (S73) data respectively encoded by the first encoding circuit (106) and/or the second encoding circuit (107), into the input buffer memory of the third encoding circuit (108),
   - encoding (S74) the data in the input buffer memory, by the third encoding circuit (108).

13. Encoding method (70) according to claim 12, comprising, in parallel with the encoding (S74) by the third encoding circuit (108), a writing, in parallel, of data of another data packet to be encoded, into the respective input buffer memories of the first encoding circuit, second encoding circuit, and third encoding circuit.

14. Encoding method (70) according to claim 12 or 13, wherein, the encoding device (10) comprising a buffer memory between the first multiplexer circuit (102) and the second multiplexer circuit (103), the data of the data packet are written into said buffer memory in parallel with the writing into the respective input buffer memories of the first encoding circuit (106), second encoding circuit (107), and third encoding circuit (108).

15. Configuration program product comprising instructions which, when implemented by a computer to configure a programmable logic device, configure said programmable logic device to form an encoding device (10) according to any one of claims 1 to 8.

Fig. 1

Fig. 2

**Fig. 3**

**Fig. 4**

**Fig. 5**

**Fig. 6**

**Fig. 7**

Fig. 8

Fig. 9

Fig. 10

Fig. 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016154697 A1

- US 2011264987 A1

**Littérature non-brevet citée dans la description**

- **ALFIRAS MOHANAD et al.** Hybrid concatenated LDPC codes with LTE modulation schemes. *International Journal of Advanced Computer Science and Applications,* 2019, vol. 10 (5
- **CHRISTIAN KOLLER et al.** Hybrid concatenated codes with asymptotically good distance growth. *IEEE Proceedings 5th International Symposium on Turbo Codes and Related Topics,* 2008, 19-24
- **YIFEI ZHANG et al.** Structured eIRA codes with low floors. *Proceedings International Symposium on Information Theory,* 2005, 174-178
- **THEODOROPOULOS DIMITRIS et al.** Efficient Architectures for Multigigabit CCSDS LDPC Encoders. *IEEE Transactions on Very Large Scale Integration Systems,* 2020, vol. 28 (5), 1118-1127

- **LIANG CHEN et al.** Implementation of multi-rate quasi-cyclic low-density parity-check codes. *The 9th International Conférence on Advanced Communication Technology,* 2007, vol. 2, 1066-1070
- **M. P. C. FOSSORIER.** Quasicyclic low-density parity-check codes from circulant permutation matrices. *IEEE Transactions on Information Theory,* Août 2004, vol. 50 (8), 1788-1793
- **T. J. RICHARDSON ; M. A. SHOKROLLAHI ; R. L. URBANKE.** Design of capacity-approaching irregular low-density parity-check codes. *IEEE Transactions on Information Theory,* Février 2001, vol. 47 (2), 619-637